(19) Europäisches Patentamt
European Patent Office
Office européen des brevets

(11) **EP 0 995 272 B1**

(12) **FASCICULE DE BREVET EUROPEEN**

(45) Date de publication et mention
de la délivrance du brevet:
**22.08.2007 Bulletin 2007/34**

(21) Numéro de dépôt: **99916954.3**

(22) Date de dépôt: **29.04.1999**

(51) Int Cl.:
***H03M 13/29*** *(2006.01)*

(86) Numéro de dépôt international:
**PCT/FR1999/001018**

(87) Numéro de publication internationale:
**WO 1999/057816 (11.11.1999 Gazette 1999/45)**

(54) **DECODAGE ITERATIF DE CODES PRODUITS**

ITERATIVE DEKODIERUNG VON PRODUKTKODEN

PRODUCT CODE ITERATIVE DECODING

(84) Etats contractants désignés:
**DE ES FR GB IT SE**

(30) Priorité: **04.05.1998 FR 9805612**

(43) Date de publication de la demande:
**26.04.2000 Bulletin 2000/17**

(73) Titulaire: **Alcatel Lucent**
**75008 Paris (FR)**

(72) Inventeurs:
• **BUDA, Fabien**
**F-75006 Paris (FR)**
• **FANG, Juing**
**F-92300 Levallois (FR)**

(74) Mandataire: **Esselin, Sophie et al**
**Marks & Clerk France**
**31-33 Avenue Aristide Briand**
**94117 Arcueil Cedex (FR)**

(56) Documents cités:
**EP-A- 0 654 910**

• **FOSSORIER M P C ET AL: "SOFT-DECISION DECODING OF LINEAR BLOCK CODES BASED ON ORDERED STATISTICS" IEEE TRANSACTIONS ON INFORMATION THEORY, vol. 41, no. 5, 1 septembre 1995 (1995-09-01), pages 1379-1396, XP000542626**
• **RAMESH PYNDIAH ET AL: "NEAR OPTIMUM DECODING OF PRODUCT CODES" PROCEEDINGS OF THE GLOBAL TELECOMMUNICATIONS CONFERENCE (GLOBECOM), SAN FRANCISCO, NOV. 28 - DEC. 2, 1994, vol. 1, 28 novembre 1994 (1994-11-28), pages 339-343, XP000488569 INSTITUTE OF ELECTRICAL AND ELECTRONICS ENGINEERS**
• **CHASE D: "A CLASS OF ALGORITHMS FOR DECODING BLOCK CODES WITH CHANNEL MEASUREMENT INFORMATION" IEEE TRANSACTIONS ON INFORMATION THEORY, vol. 18, no. 1, 1 janvier 1972 (1972-01-01), pages 170-182, XP000500203**

**Description**

L'invention concerne le décodage de codes produits de codes linéaires en blocs. Elle s'applique au domaine des transmissions, pour le codage de canal. Un canal de transmission typique comprend une source binaire, un codeur, un modulateur qui émet dans un canal, un démodulateur en sortie de canal, et un décodeur qui fournit le signal binaire. Le codage de canal a pour but de réduire la puissance nécessaire pour atteindre un taux d'erreur bit donné. La demande de brevet française déposée le 09 Octobre 1997 sous le numéro 9712594, sous le titre "Procédé de codage bloc par code produit applicable notamment au codage d'une cellule ATM" donne une description des notions de base de la transmission et du codage de canal, à laquelle on pourra se reporter pour plus de détails. Dans la mesure où l'invention concerne le décodage de canal, les autres éléments du système de transmission - tels le codage de source et la modulation démodulation utilisée en fonction du milieu de transmission - ne font pas l'objet de plus d'explications.

Il est classique d'utiliser pour le codage des codes redondants et des codes produits. On caractérise généralement un code $C_1$ par un triplet $(n_1, k_1, d_1)$, ou $k_1$ est le nombre de bits en entrée du code, $n_1$ est le nombre de bits en sortie du code et $d_1$ est la distance minimale de Hamming du code. L'application d'un tel code à un k-uplet $(x_1, ..., x_k)$ fournit un n-uplet $(x_1,..., x_k, x_k+ 1, ..., x_n)$ avec n-k bits de redondance.

On appelle code produits l'application successive de deux codes $C_1$ et $C_2$, de la façon suivante. On considère $k_1.k_2$ bits, sous forme de $k_2$ mots de $k_1$ bits. On applique aux $k_2$ mots de $k_1$ bits un code $C_1(n_1, k_1, d_1)$ et on obtient $k_2$ mots de $n_1$ bits. Rangés sous forme de matrice, ces $k_2$ mots de $n_1$ bits forment $n_1$ colonnes, la j-ième colonne étant formée des j-ièmes bits de chacun des $k_2$ mots. On applique à chacune de ces $n_1$ colonnes de $k_2$ bits un code $C_2(n_2, k_2, d_2)$ pour obtenir $n_1$ mots de $n_2$ bits. L'application d'un tel code produit permet de passer de $k_1.k_2$ bits à $n_1.n_2$ bits, avec $n_1.n_2 - k_1.k_2$ bits de redondance. Si les codes sont linéaires, on obtient de la sorte $n_2$ lignes de mots du code $C_1$, ou $n_1$ colonnes de mots du code de $C_2$. Le code produit est un code présentant les paramètres $(n_1.n_2; k_1.k_2; d_1.d_2)$. L'ordre d'encodage est indifférent, et l'on obtient les mêmes résultats en codant d'abord les lignes, comme décrit ci-dessus, ou en codant d'abord les colonnes. De tels codes produits sont décrits dans la littérature pour le codage de canal. La demande française susmentionnée, ou encore la figure 2 de FR-A-2 712 760 expliquent en détail le principe du codage par un tel code produit.

Le problème avec de tels codes produits est le décodage en sortie du démodulateur. On obtient en sortie du démodulateur des ensembles de valeurs de bits (généralement modulés sous la forme $\pm 1$), entachées d'un bruit. On appelle valeur souple la valeur reçue, entachée du bruit, qui est une valeur réelle; on appelle valeur ferme la valeur $\pm 1$, i.e. la valeur binaire correspondante, obtenue par une décision à seuil sur la valeur reçue. On appelle dans la suite mot ferme un mot binaire, et mot souple un mot effectivement reçu, formé de valeurs réelles.

Lors d'une transmission avec codage par un code produit, on obtient en sortie du démodulateur un ensemble $\underline{R} = \{r_{i,j}\}$ de $n_1.n_2$ valeurs réelles (valeurs souples). Le décodage consiste à déterminer à quel mot du code produit $C_1 .C_2$ correspondent ces valeurs souples, selon un certain critère de performance. Si le bruit est un bruit additif blanc gaussien, la solution optimale consiste à rechercher le mot du code produit qui minimise la distance euclidienne au mot souple reçu $\underline{R}$. Ce critère du maximum de vraisemblance est dans la pratique impossible, dès lors que le produit $k_1.k_2$ dépasse couramment quelques centaines.

Diverses solutions ont donc été proposées pour assurer le décodage des codes produits. La solution la plus immédiate consiste à prendre des décisions fermes sur chacun des bits du mot souple reçu, et à décoder en décision ferme successivement les lignes puis les colonnes, en appliquant un décodeur du code $C_2$ sur les colonnes, puis un décodeur du code $C_1$ sur les lignes; cette solution est largement sous optimale, et ne permet pas d'atteindre le gain théorique d'un code produit car elle n'utilise pas toute l'information reçue du canal de transmission.

FR-A-2 712 760 propose un algorithme de décodage itératif de codes produits $C_1.C_2$, dans lequel on procède à plusieurs reprises au décodage successif des différentes colonnes ou lignes de la matrice formée à partir du mot de code produit reçu. Pour chaque colonne ou ligne, i.e. pour chaque mot du code $C_2$ ou $C_1$ reçu affecté d'un bruit (mot souple reçu), ce document propose de procéder au décodage à l'aide d'un algorithme de Chase modifié, et plus exactement :

- de générer un ensemble de mots fermes du code $C_2$ ou $C_1$ a priori proches du mot souple reçu sur la ligne ou colonne correspondante;
- calculer la distance euclidienne entre ces différents mots fermes et le mot souple reçu; et
- choisir comme mot de code reçu celui des différents mots fermes qui présente la distance minimale au mot souple effectivement reçu.

Pour générer l'ensemble des mots fermes du code $C_2$ (ou $C_1$) a priori proches du mot souple reçu, ce document propose:

- de repérer les p composantes les moins fiables du mot souple reçu;

- de construire q séquences binaires de test à partir de ces p composantes les moins fiables;
- de construire q mots binaires à décoder à partir de ces séquences de tests binaires et d'une valeur courante binaire du mot décodé; cette valeur courante binaire est initialisée au départ par une approximation binaire de chacun des bits reçus;
- de décoder les q mots binaires avec un décodeur de Berkelamp (décodeur algébrique) pour obtenir q' mots de code, en vérifiant le cas échéant que les q' mots obtenus sont des mots du code $C_2$ (ou $C_1$).

La construction des q mots binaires et leur décodage selon cet algorithme est une opération peu efficace : les q mots générés sont des mots du code $C_2$ (ou $C_1$), mais ne sont pas forcément distincts. On obtient en sortie du décodeur un nombre q' de mots de code distincts inférieur au nombre q de mots générés.

En outre, cette méthode ne fonctionne que pour des codes pour lesquels il existe un décodeur algébrique. L'implémentation des décodeurs algébriques nécessite des calculs dans les corps de Gallois et une architecture complexe.

Juing Fang, Décodage pondéré des codes linéaires en blocs, Thèse de Docteur ingénieur, ENST de Paris, 1986, décrit un algorithme de décodage à entrée souple d'un code linéaire en bloc. Cet algorithme est optimal au sens du maximum de vraisemblance et ne fait pas intervenir explicitement la structure algébrique du code. Il permet de fournir en sortie un mot de code ferme, de vraisemblance maximale. Cet algorithme est l'un des nombreux algorithmes de décodage à entrée souple et à sortie ferme; il ne suggère pas l'utilisation de listes pour générer une sortie souple.

Il est également à noter que le document "Soft-Decision Decoding of Linear Block Codes Based on Ordered Statistics", Marc Fossorier, 05.09.1995 décrit un procédé de décodage de codes linéaires à entrées souples comprenant une étape de génération d'une liste de mots de code proches du mot de code reçu par codage d'une liste de k-uplets les plus vraisemblables.

L'invention propose une solution au décodage itératif des codes produits, qui permette un décodage plus rapide et plus efficace, et qui s'applique à tous les types de codes et pas seulement à ceux pour lesquels existe un décodeur algébrique.

Le décodage des codes produits n'est pas un problème mathématique, mais un problème technique important dans le domaine des transmissions. Il s'applique directement au décodage des valeurs des bits ou des mots de code produit reçus en sortie du démodulateur d'un canal de transmission.

Plus précisément, l'invention propose un procédé de décodage à entrée souple et à sortie souple d'un mot ($\underline{s}$) d'un code linéaire en bloc de dimension k et de longueur n, reçu depuis un canal de transmission, comprenant les étapes de

- génération d'une liste de mots fermes ($\underline{u}_b$) du code proches du mot de code reçu ($\underline{s}$), en codant une liste de k-uplets les plus vraisemblables;
- calcul de la j-ième composante du mot souple de sortie par différence entre les métriques d'une part du mot de code généré le plus proche, et d'autre part, et du mot de code généré le plus proche ayant une j-ième composante opposée.

Chacun des k-uplets de la liste de k-uplets est obtenu par:

- classement par ordre de fiabilité des composantes du mot de code reçu, suivant une permutation (T);
- vérification que les k composantes les plus fiables du mot ainsi obtenu permettent de générer les n - k autres;
- choix de valeurs fermes pour m composantes les moins fiables desdites k composantes, m étant un entier inférieur à k;
- approximation ferme des k - m autres composantes;
- codage du mot ferme ainsi obtenu, par un code égal à la composition dudit code par l'inverse de ladite permutation.

Dans un mode de réalisation, les k-uplets les plus vraisemblables sont obtenus par approximation ferme des composantes du mot reçu et par changement des composantes des moins fiables,

On peut aussi prévoir que la vérification s'effectue par

- application aux colonnes de la matrice de parité du code de la permutation;
- vérification du rang de la matrice formée des n-k dernières colonnes de la matrice de parité ainsi permutée.

L'étape de vérification, lorsqu'elle est négative, est suivie d'une étape de modification de la permutation.

Dans un autre mode de réalisation, chacun des k-uplets de la liste de k-uplets est obtenu par:

- classement par ordre de fiabilité des k premières composantes du mot de code reçu, par une permutation (T);
- choix de valeurs fermes pour m composantes les moins fiables, m étant un entier inférieur à k;

- approximation ferme des k - m autres composantes;
- codage du mot ferme ainsi obtenu, par un code égal à la composition dudit code par l'inverse de ladite permutation.

De préférence, le calcul de la j-ième composante du mot souple de sortie s'effectue, lorsqu'il n'existe pas de mot de code généré le plus proche ayant une j-ième composante opposée, par différence entre les métriques d'une part du mot de code généré le plus proche, et d'autre part, et du mot de code généré le moins proche

Il est aussi possible de prévoir que le calcul de la j-ième composante du mot souple de sortie s'effectue, lorsqu'il n'existe pas de mot de code généré le plus proche ayant une j-ième composante opposée, par addition à la j-ième composante du mot reçu par d'un coefficient du signe de la j-ième composante du mot de code le plus proche du mot reçu.

Avantageusement, le mot reçu est affecté d'un bruit blanc additif et gaussien.

L'invention a aussi pour objet un procédé de décodage à entrée souple et à sortie souple d'un mot ($\underline{s}$) d'un code linéaire en bloc de dimension k et de longueur n, reçu depuis un canal de transmission, comprenant les étapes de

- choix du mot de code le plus proche du mot reçu dans une liste de mots fermes ($\underline{u}_b$) du code proches du mot de code reçu ($\underline{s}$), générés en codant une liste de k-uplets les plus vraisemblables,
- pour chaque composante d'ordre j du mot reçu, j variant de 1 à n:

    * remplacement de la j-ième composante du mot reçu par l'inverse de la j-ième composante du dit mot de code de plus proche;
    * choix du mot de code le plus proche du mot obtenu dans l'étape de remplacement dans une liste de mots fermes du code proches du mot de code obtenu dans l'étape de remplacement, générés en codant une liste de k-uplets les plus vraisemblables;
    * calcul de la j-ième composante du mot souple de sortie par différence entre les métriques d'une part du mot de code le plus proche du mot reçu, et d'autre part, et du mot de code le plus proche du mot obtenu dans l'étape de remplacement.

Dans un mode de réalisation, dans l'étape du choix du mot de code le plus proche du mot reçu, les k-uplets les plus vraisemblables sont obtenus par approximation ferme des composantes les plus fiables du mot reçu et par changement des composantes les moins fiables.

De préférence, dans l'étape du choix du mot de code le plus proche du mot obtenu dans l'étape de remplacement, les k-uplets les plus vraisemblables sont obtenus par approximation ferme des composantes les plus fiables du mot obtenu dans l'étape de remplacement et par changement des composantes les moins fiables.

Dans un mode de réalisation, le mot reçu est affecté d'un bruit blanc additif et gaussien.

L'invention a encore pour objet un procédé de décodage itératif d'un mot ($\underline{R}$) d'un code produit reçu depuis un canal de transmission, comprenant pour au moins une itération, un décodage à entrée souple et à sortie souple de lignes ou de colonnes dudit mot du code produit, selon un tel procédé.

D'autres caractéristiques et avantages de l'invention apparaîtront à la lecture de la description qui suit de modes de réalisation de l'invention, donnée à titre d'exemple et en référence aux dessins annexés qui montrent:

- figure 1 un ordinogramme d'un premier mode de réalisation d'un procédé de décodage à entrée souple et à sortie souple mis en oeuvre dans l'invention;
- figure 2 un ordinogramme d'un deuxième mode de réalisation d'un procédé de décodage à entrée souple et à sortie souple mis en oeuvre dans l'invention;
- figure 3 un ordinogramme d'un troisième mode de réalisation d'un procédé de décodage à entrée souple et à sortie souple mis en oeuvre dans l'invention;
- figure 4 un ordinogramme d'un algorithme de décodage itératif selon l'invention;
- figure 5, un schéma du fonctionnement du décodeur de l'invention pour un nombre d'itérations égal à 4;
- figures 6 et 7, des représentations graphiques de résultats des procédés de l'invention.
-

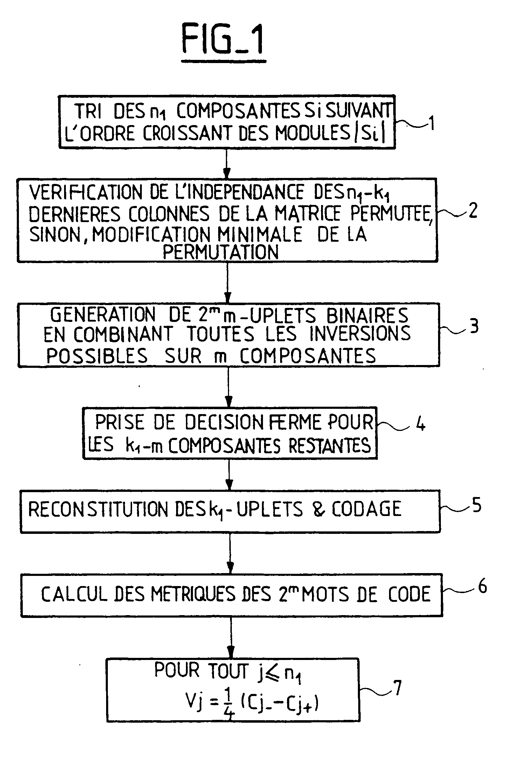

Pour déterminer dans un algorithme de décodage à entrée souple et à sortie souple un ensemble de mots de codes a priori proches du mot de code souple reçu, l'invention propose d'utiliser non pas un décodage, mais un encodage. La figure 1 montre un ordinogramme d'un premier mode de réalisation d'un procédé de décodage à entrée souple et à sortie souple mis en oeuvre dans l'invention; on a représenté à la figure 1 les étapes nécessaires au décodage à sortie souple d'un mot souple reçu sur une ligne ou une colonne du mot de code produit reçu.

On note dans la suite de la description $\underline{R} = \{r_{i,j}\}$ le mot souple de code produit reçu depuis le canal de transmission, $1 \leq i \leq n_1$, $1 \leq j \leq n_2$. Ce mot souple correspond à la transmission sur le canal d'un mot binaire ou ferme du code produit $C_2.C_1$, qui parvient au décodeur de canal entaché de bruit. On considère une représentation des valeurs souples dans l'ensemble des réels, les valeurs fermes correspondant à $\pm 1$. Dans une telle représentation, le module de la valeur souple reçue est indicatif de la fiabilité de la valeur, et son signe donne la valeur ferme reçue. On décrit en référence à la figure 1 le décodage d'une ligne de ce mot de code; le même procédé s'applique mutatis mutandis au décodage des colonnes de ce mot de code produit. On considère donc le mot souple correspondant à une ligne donnée $\underline{s} = \{s_i, 1 \leq i \leq n_1\}$, avec $s_i = r_{i,j}$, pour j donné. Ce mot est une version entachée d'erreur d'un mot du code $C_1(n_1, k_1, d_1)$. Ce mot contient $k_1$ bits fournis par le codeur de source, et $n_1-k_1$ bits de redondance générés par le code $C_1$. Pour plus de simplicité dans l'exposé, on a considéré la forme systématique du code, dans laquelle les $k_1$ composantes d'entrée se retrouvent telles quelles dans le mot de code de sortie.

Dans une première étape 1, on trie l'ensemble des composantes reçues $s_i$ suivant l'ordre croissant des modules $|s_i|$, i.e. suivant la fiabilité. On note T la permutation correspondante.

Dans une deuxième étape 2, on vérifie que les $k_1$ dernières composantes de l'image $T(s_i)$ de $s_i$ dans la permutation permettent de retrouver les $n_1-k_1$ restantes; ceci peut s'effectuer en appliquant la permutation T aux colonnes de la matrice de parité du code $C_1$, et en vérifiant que les $n_1-k_1$ dernières colonnes de la matrice permutée obtenue sont indépendantes. Si elles ne le sont pas, on modifie la permutation T, de sorte à obtenir $n_1-k_1$ dernières colonnes indépendantes lorsque l'on applique la permutation aux colonnes de la matrice de parité. Ceci peut s'effectuer en changeant la j-ième colonne, $j \leq [n_1 -k_1 + 1, n_1]$, i.e. en composant T avec une permutation $(p, n_1-k_1 + i)$, où p est un entier inférieur ou égal à $k_1$. Dans la suite du procédé, jusqu'à l'étape 8, on travaille dans cet espace permuté, sur les mots de code permutés.

Dans une troisième étape 3, on considère m, $m<k_1$ des $k_1$ dernières composantes du mot reçu permuté, par exemple les m composantes les moins fiables, et on crée des m-uplets correspondants en leur affectant des valeurs binaires. On peut générer de cette façon $2^m$ m-uplets binaires, mais il peut être plus intéressant de générer uniquement certains de ces $2^m$ m-uplets, par exemple ceux qui ont la plus petite métrique.

Dans une quatrième étape 4, on considère les $k_1$-m composantes restantes parmi les $k_1$ dernières composantes. On effectue pour chacune de ces composantes une décision ferme, c'est à dire que l'on affecte à chaque composante souple une valeur ferme ou binaire. On peut par exemple simplement affecter à chaque composante son signe.

A la cinquième étape 5 on reconstitue à partir des résultats des troisième et quatrième étapes un ensemble de mots binaires $\underline{t}_b = \{t_i, 1 \leq i \leq k_1\}_b$, avec $b \leq 2^m$. En d'autres termes, chaque mot obtenu à l'étape 5 est un assemblage ou une concaténation des m composantes créées à l'étape 3 et des $k_{1-m}$ composantes obtenues à l'étape 4. On leur applique le codage, qui dans l'espace des mots permutés, correspond au codage $C_1$.

Une méthode pour faire ce codage est d'utiliser la matrice de parité H du code $C_1$. La permutation T associée au tri des composantes sera appliquée à la matrice de parité H du code. On applique ensuite une réduction de Gauss aux $(n_1-k_1)$ colonnes les plus à droite de la matrice H permutée par la liste T afin de la mettre sous forme systématique. Il est à remarquer qu'en général les $(n_1-k_1)$ dernières colonnes de la matrice H permutée ne sont pas indépendantes. Dans ce cas, on peut modifier la permutation T afin de rendre ces colonnes indépendantes et de pouvoir ainsi systématiser la matrice H permutée. La vérification proposée à l'étape 2 peut se faire en même temps que la systématisation de la matrice permutée. On utilise ensuite avantageusement cette matrice de parité rendue systématique pour l'encodage dans l'espace permuté.

On obtient ainsi directement des mots fermes permutés $\underline{u}_b = \{u_i, 1 \leq i \leq n_1\}b$ du code correspondant, qui a priori sont proches de la version permutée du mot qui a été envoyé sur le canal de transmission.

On peut ensuite, à la sixième étape 6, calculer pour chacun des mots de code $\underline{u}_b$ obtenus, la distance euclidienne au mot de code souple si reçu. On peut dans cette étape ne conserver parmi ces mots de code que les mots les plus fiables, la mesure de la fiabilité s'effectuant simplement en considérant la distance euclidienne qui vient d'être calculée; le seuil utilisé pour retenir les mots de codes, ou encore le nombre de mots de code considéré, dépend du nombre total de mots de code que l'on a généré dans les étapes précédentes. En d'autres termes, plus on génère de mots de codes, plus le nombre de mots de code que l'on peut garder est important. Le choix du nombre de mots de codes retenus résulte d'un compromis entre la complexité provoquée par la génération d'un grand nombre de mots de codes, d'une part, et d'autre part l'avantage que la probabilité de trouver des mots de codes très fiables augmente lorsque le nombre total de mots de codes générés croît.

A l'étape 7, on procède au décodage souple de la façon suivante. Pour une composante donnée reçue $s_j$ d'ordre j donné, on considère dans l'ensemble des mots de code $\underline{u}_b$ obtenus, le mot de code le plus proche $\underline{u}_j^+$ présentant comme composante d'ordre j un bit à 1 et le mot de code le plus proche $\underline{u}_j^-$ présentant comme composante d'ordre j un bit à -1; on calcule alors la valeur de la j-ième composante du mot souple décodé comme la différence, multipliée par un facteur de normalisation d'un quart entre la métrique $c_j- = |\underline{u}_j^- - \underline{s}|$ du mot de code $\underline{u}_j^-$ le plus proche présentant un bit à -1 en j-ième position et la métrique $c_j + = |\underline{u}_j^+ - \underline{s}|$ du mot de code $\underline{u}_j^+$ le plus proche présentant un bit à +1 en j-ième position. En d'autres termes, pour chaque valeur de j, on calcule la composante $v_i$ d'ordre j du mot de code souple $\{v_i, 1 \leq i \leq n_1\}$ fourni par le décodeur comme

$$v_i = (c_{i-} - c_{i+})/4$$

Il est possible, en fonction du nombre de mots générés à l'étape 5 et retenus à l'étape 6, qu'on ne trouve pas dans l'ensemble de mots de code générés deux mots de code présentant des valeurs de bits opposées dans la j-ième position; ce peut être le cas si la composante d'ordre j est reçue avec une grande fiabilité. Ce peut aussi être le cas si l'on a généré ou retenu un faible nombre de mots de codes. On peut alors prendre comme valeur souple de la j-ième composante la différence entre la métrique la plus faible - celle du mot de la liste le plus proche du mot de code reçue

- et la métrique la plus forte - celle du mot de la liste le plus éloigné du mot de code reçu. Dans ce cas, on trouve une valeur précise d'une des deux métriques; l'autre métrique est approximée ou du moins on en considère une borne inférieure, en prenant la métrique du mot de code de la liste le plus éloigné.

On pourrait aussi, toujours dans ce cas, prendre comme valeur souple de la j-ième composante la somme de la j-ième composante du mot reçu et d'un facteur b, affecté du signe de la décision ferme de la j-ième composante du mot de code le plus proche; en d'autres termes, on ajoute le facteur b si la j-ième composante du mot de code le plus proche est positive, et on ajoute -b si la j-ième composante du mot de code le plus proche est négative; la valeur de ce facteur peut varier en fonction de l'itération.

On peut ensuite repasser dans l'espace des mots reçu, en appliquant une permutation inverse de celle de l'étape 2. On trouve alors le mot de code le plus proche du mot reçu plus tous les coefficients de fiabilité de chaque symbole, i. e. une sortie pondérée.

On fournit maintenant une explication du calcul de l'étape 7. On considère le cas d'un bruit blanc gaussien additif $\underline{b}$, dont les composantes $b_i$ sont à moyenne nulle et de même variance $s^2$. On peut alors noter

$$\underline{s} = \underline{e} + \underline{b}$$

avec $\underline{s}$ le mot reçu, comme expliqué plus haut, $\underline{e} = (e_i, 1 \leq i \leq n_1)$ le mot de code émis avec $e_i = \pm 1$, et $\underline{b} = (b_i, 1 \leq i \leq n_1)$. Dans ce cas, la mesure de fiabilité associée à chaque symbole $c_i$ du mot décodé peut être déterminée à partir du logarithme du rapport de vraisemblance défini par

$$L(c_i) = \log[Pr(c_i = 1/\underline{s})/Pr(c_i = -1/\underline{s})]$$

Dans ce cas, en utilisant la règle de Bayes, et en tenant compte du fait que le bruit est blanc et gaussien, on montre que le rapport de vraisemblance associé au symbole $c_i$ est égal à:

$$L(c_i) = \log \frac{\sum_{\underline{u}^+ \in S_{1,j}} \exp[-\frac{1}{2\sigma^2} M(\underline{s}, \underline{u}^+)]}{\sum_{\underline{u}^- \in S_{-1,j}} \exp[-\frac{1}{2\sigma^2} M(\underline{s}, \underline{u}^-)]}$$

où $S_{1,j}$ et $S_{-1,j}$ sont les deux ensembles des mots du code dont le $j^{\text{ème}}$ symbole vaut + 1 ou -1 respectivement, $M(\underline{s}, \underline{u})$ étant la métrique entre le mot de code $\underline{u}$ trouvé par l'algorithme et le mot reçu $\underline{s}$, métrique qui dans notre cas est la distance euclidienne entre $\underline{s}$ le mot reçu et $\underline{u}$ un mot du code, distance euclidienne qui peut être en précision finie. Cette métrique peut si nécessaire être adaptée aux cas des canaux à évanouissements.

Le nombre de mots de code étant généralement élevé, le calcul du rapport de vraisemblance est relativement complexe. Lorsque le rapport signal à bruit est suffisamment grand, on peut simplifier cette expression en ne conservant au numérateur et au dénominateur que le terme le plus fort, l'expression du logarithme du rapport de vraisemblance devient alors :

$$L(c_i) \approx \log \frac{\underset{\underline{u}^+ \in S_{1,j}}{Max} \exp[-\frac{1}{2\sigma^2} M(\underline{s},\underline{u}^+)]}{\underset{\underline{u}^- \in S_{-1,j}}{Max} \exp[-\frac{1}{2\sigma^2} M(\underline{s},\underline{u}^-)]} = \frac{1}{2\sigma^2}\left( \underset{\underline{u}^- \in S_{-1,j}}{Max} M(\underline{s},\underline{u}^-) - \underset{\underline{u}^+ \in S_{1,j}}{Max} M(\underline{s},\underline{u}^+) \right)$$

En normalisant le logarithme du rapport de vraisemblance par le facteur $\frac{\sigma^2}{2}$, la sortie pondérée du $j^{\text{ème}}$ symbole $v_j$ s'exprime alors de la manière suivante :

$$v_j = \frac{1}{4}\left( \underset{\underline{u}^- \in S_{-1,j}}{Max} M(\underline{s},\underline{u}^-) - \underset{\underline{u}^+ \in S_{1,j}}{Max} M(\underline{s},\underline{u}^+) \right)$$

où Sij représente l'ensemble des mots du code ayant un symbole égal à i (i=±1) en position j. En reprenant les notations précédentes pour $c_{j-}$ et $c_j+$, on retrouve bien l'expression de l'étape 7 de la figure 1 :

$$v_j = \frac{1}{4}\left( c_{j-} - c_{j+} \right)$$

Les étapes décrites en référence à la figure 1 permettent de générer des mots de code, qui sont proches du mot souple reçu sur le canal de transmission. Le procédé de la figure 1 permet en trouvant une liste de mots du code, d'en déduire une valeur souple de chaque composante du mot de code reçu. La complexité du procédé dépend du nombre de mots de codes générés à l'étape 4, autrement dit du nombre de mots de code proches générés. Plus ce nombre est important, plus le procédé est performant, mais plus il est complexe à mettre en oeuvre; plus ce nombre est faible, plus le procédé est performant, et moins il est efficace. Le choix du nombre de mots de code détermine le rapport performance/complexité du procédé, et est adapté en fonction des circonstances. Dans la pratique des résultats satisfaisants sont obtenus pour un code BCH(31, 21) étendu en conservant les 19 meilleurs mots de code parmi 50 mots générés.

En variante de l'étape 2, on peut changer non pas les composantes les moins fiables, mais les composantes, qui en combinaison, sont les moins fiables: ainsi si on considère par exemple les composantes suivantes, avec les modules correspondants:

| $l_1$ | $l_2$ | $l_3$ | $l_4$ | $l_5$ | $l_6$ |
|---|---|---|---|---|---|
| 0,1 | 0,2 | 0,3 | 0,35 | 0,4 | 0,45 |

on changera par exemple $l_1$, puis $l_2$, puis $l_3$, puis $l_1$ et $l_2$, puis $l_4$, puis $l_1$ et $l_3$, puis $l_5$, et ainsi de suite. On arrive ainsi à préserver les composantes les plus fiables.

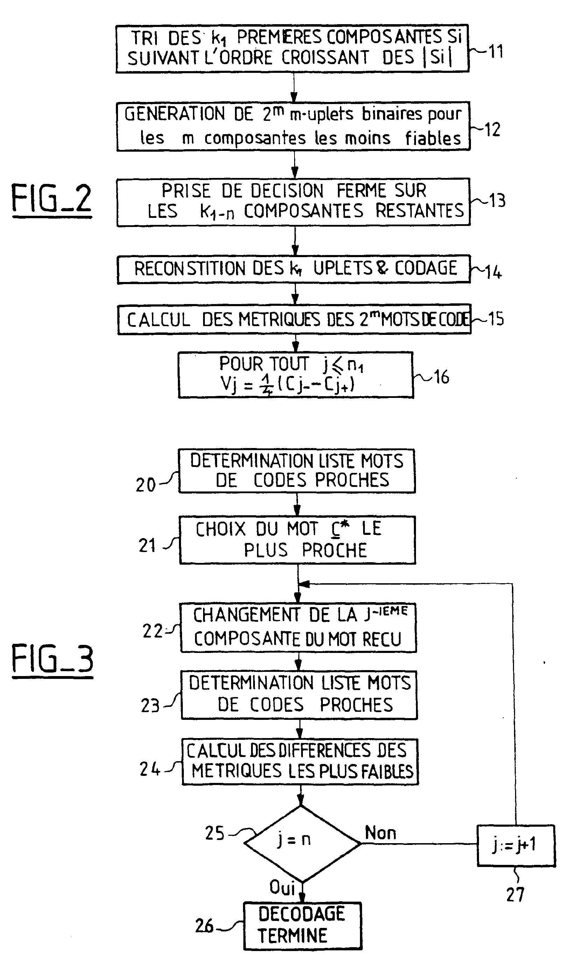

La figure 2 montre un ordinogramme d'un deuxième mode de réalisation d'un procédé de décodage à entrée souple et à sortie souple mis en oeuvre dans l'invention; de nouveau, on n'a considéré à la figure 2 que l'exemple d'une ligne. De nouveau, on décrit l'invention en référence à la forme systématique du code. On considère le mot souple correspondant à une ligne donnée $\{s_i, 1 \leq i \leq n_1\}$, avec $s_i = r_{i,j}$, pour j donné. Ce mot est une version entachée d'erreur d'un mot du code $C_1(n_1, k_1, d_1)$. Ce mot contient $k_1$ bits fournis par le codeur de source, et $n_1-k_1$ bits de redondance générés par le code $C_1$.

Dans une première étape 11, on trie les $k_1$ premières composantes reçues $s_i$ suivant l'ordre croissant des modules $|s_i|$, i.e. suivant la fiabilité. On note T la permutation correspondante.

Dans une deuxième étape 12, on procède comme dans l'algorithme de Chase, et on crée des vecteurs fermes pour les m, m<$k_1$ composantes les moins fiables. On peut générer de cette façon $2^m$ m-uplets, mais il peut être plus intéressant de générer uniquement certains de ces $2^m$ m-uplets, par exemple ceux qui ont la plus petite métrique euclidienne. Dans le cas où $k_1=4$ et $m=2$, les vecteurs générés sont par exemple 00, 10, 01, 11.

Dans une troisième étape 13, on considère les $k_1$-m composantes restantes et on effectue pour chacune de ces composantes une décision ferme, c'est à dire que l'on affecte à chaque composante souple une valeur ferme ou binaire. On peut par exemple simplement affecter à la composante $s_i$ d'ordre i la valeur sign($s_i$).

A l'étape 14 on reconstitue à partir des résultats de l'étape 12 et de l'étape 13 un ensemble de mots binaires $\underline{t}_b = \{t_i, 1 \le i \le k_1\}_b$, avec $b \le 2^m$, par concaténation des m composantes obtenues à l'étape 12, et des $k_1$-m composantes obtenues à l'étape 13. On applique à ces mots fermes le codage $C_1.T^{-1}$, où $T^{-1}$ est l'inverse de la permutation T de l'étape 1. On obtient ainsi directement des mots fermes $\underline{u}_b = \{u_i, 1 \le i \le n_1\}_b$ du code $C_1$, qui a priori sont proches du mot qui a été envoyé sur le canal de transmission.

On peut ensuite, à l'étape 15, calculer pour chacun des mots de code $\underline{u}_b$ obtenus, la distance euclidienne au mot de code souple si reçu, ou métrique de chaque mot de code $\underline{u}_b$ par rapport au mot de code $\underline{s}$ reçu. On peut dans cette étape ne conserver parmi ces mots de code que les mots les plus fiables, comme expliqué plus haut en référence à l'étape 6 de la figure 1.

A l'étape 16, on procède au décodage souple, de la même façon qu'à l'étape 7 de la figure 1.

Le procédé de la figure 2, par rapport à celui de la figure 1, permet d'éviter l'étape de vérification de l'indépendance des dernières colonnes de la matrice de parité. Il présente l'inconvénient, par rapport à ce même procédé de la figure 1, de ne modifier des composantes que parmi les $k_1$ premières, et non parmi l'ensemble des composantes du mot de code. En d'autres termes, le procédé de la figure 1 permet de modifier des composantes de faible fiabilité qui sont choisies non seulement parmi les informations envoyées, mais aussi parmi les valeurs de redondance. On arrive ainsi à changer les composantes les moins fiables parmi les $k_1$ plus fiables du mot de code dans son ensemble, et pas seulement parmi les $k_1$ premières composantes du mot envoyé.

La figure 3 montre un ordinogramme d'un troisième mode de réalisation d'un procédé de décodage à entrée souple et à sortie souple mis en oeuvre dans l'invention. On procède dans ce mode de réalisation comme dans les cinq premières étapes de la figure 1 pour obtenir une listes de mots de codes, et leurs métriques; ceci est symbolisé à la figure 3 par l'étape 20. On considère à l'étape 21 le mot de code le plus proche $\underline{c}*$, i.e. celui présentant la métrique la plus faible, et on initialise une valeur courante j à 1.

A l'étape 22, on change la valeur de la j-ième composante $s_j$ du mot de code $\underline{s}$ reçu, pour lui donner une valeur opposée à celle de la j-ième composante du mot de code $\underline{c}*$ déterminé à l'étape 21, et ce avec une très grande fiabilité.

A l'étape 23, on procède, comme dans les cinq premières étapes de la figure 1 à une recherche d'une liste de mots de codes proches du mot reçu modifié à sa j-ième composante, et au calcul de leur métrique.

A l'étape 24, on considère le mot de code $\underline{c}'*$ présentant la métrique la plus faible; la composante d'ordre j de $\underline{c}'*$ est opposée à cette du mot de code $\underline{c}*$ déterminé à l'étape 21; on calcule alors la composante $v_j$ d'ordre j du mot souple de sortie $\underline{v}$ comme la différence des métriques des mots $\underline{c}*$ et $\underline{c}'*$ des étapes 21 et 24, multipliée par le facteur de normalisation 1/4.

A l'étape 25, on compare j et n. Si j=n, on a terminé de décodage, étape 26; sinon, à l'étape 27, on incrémente j de un et on repasse à l'étape 22.

Par rapport aux procédés des figures 1 et 2, le procédé de la figure 3 donne de meilleurs résultats dans la mesure où l'on retrouve nécessairement pour chaque composante deux mots de codes ayant pour cette composante des valeurs de bits opposées. Toutefois, ce procédé est plus complexe, dans la mesure où l'on doit calculer des listes de mots proches $n_1 + 1$ fois et non pas une seule fois.

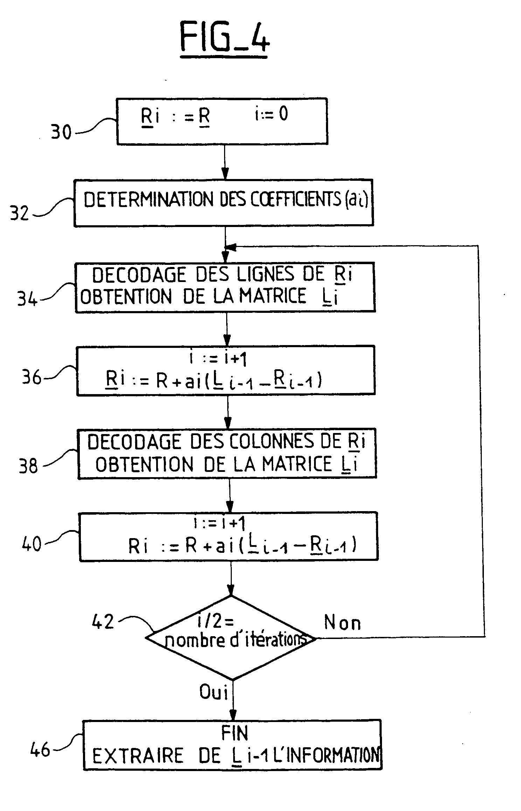

Les procédés des figures 1 à 3 fournissent donc une sortie souple pour chaque ligne ou chaque colonne du mot de code produit reçu depuis le canal de transmission. Le procédé de décodage de l'invention utilise ce décodage souple pour le décodage itératif, comme expliqué en référence à la figure 4, qui montre un mode de réalisation d'un tel décodage itératif. Dans une itération, on utilise le procédé d'une des figures 1 à 3, ou une combinaison de ces procédés pour obtenir à partir des lignes, et respectivement des colonnes, de la matrice courante, des lignes et respectivement des colonnes pour l'itération suivante.

Dans une première étape 30, on initialise une matrice courante $\underline{R}_i$ à la valeur reçue du canal $\underline{R}$, la valeur de l'indice i étant initialisée à 0. On passe ensuite à l'étape 32.

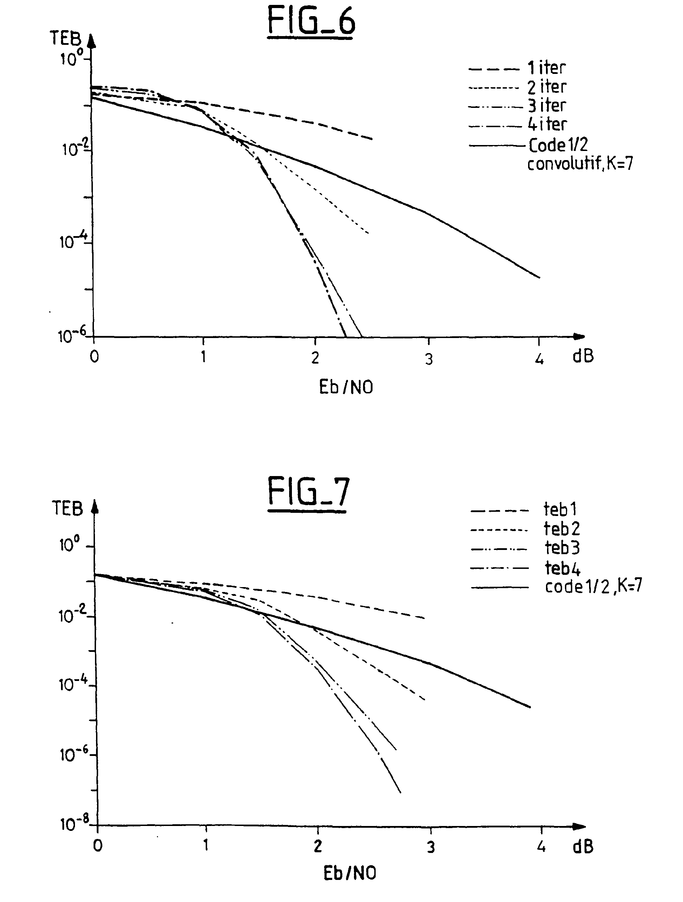

A l'étape 32, on détermine des coefficients $a_i$ pour chaque valeur de i. Les coefficients en cause forment une suite croissante $(a_i)$ de réels. Des valeurs de ces coefficients sont données à titre d'exemple pour un code produit BCH (31,21) étendu en référence à la figure 6.

On passe ensuite à l'étape 34.

Un premier décodage suivant les lignes de la matrice $\underline{R}_i$ en utilisant l'un ou l'autre des algorithmes de décodage en entrée souple et à sortie souple des figures 1 à 3 permet de déterminer une nouvelle matrice $\underline{L}_i$ dont chaque ligne est un mot du code $C_1$. On passe ensuite à l'étape 36.

A l'étape 36, on incrémente i de 1. On extrait de la matrice $\underline{L}_{i-1}$ une information extrinsèque égale à $(\underline{L}_{i-1}-\underline{R}_{i-1})$ qui pondérée par le facteur $a_i$ est ajoutée à la matrice $\underline{R}$ reçue. On calcule une nouvelle matrice $\underline{R}_i=\underline{R}+a_i(\underline{L}_{i-1}-\underline{R}_{i-1})$ avant

de passer à l'étape 38.

A l'étape 38, on poursuit en décodant les colonnes de la matrice $\underline{R}_i$ en utilisant l'un ou l'autre des algorithmes de décodage en entrée souple et à sortie souple des figures 1 à 3. Ce décodage permet d'obtenir une matrice $\underline{L}_i$ dont chaque ligne est un mot du code $C_2$. Cette étape 38 correspond pour ce qui est des colonnes à l'étape 34. On passe ensuite à l'étape 40.

L'étape 40 correspond à l'étape 36. Elle consiste à incrémenter i de 1 et à former une nouvelle matrice $\underline{R}_i = \underline{R} + a_i$ $(\underline{L}_{i-1} - \underline{R}_{i-1})$.

A l'étape 42, on compare le nombre d'itérations, égal à i/2, au nombre d'itérations souhaitées. Il est à noter que l'on appelle itération l'ensemble comprenant un décodage des lignes et un décodage des colonnes. S'il faut procéder à une itération supplémentaire, on passe à l'étape 34 et sinon on passe à l'étape 46.

A l'étape 46, on prend des décisions binaires sur la matrice $\underline{L}_{i-1}$, obtenue par décodage des colonnes à l'étape 38. On suppose que la matrice ainsi obtenue correspond au mot de code émis, il suffit alors d'extraire la sous-matrice d'information pour retrouver les bits d'information.

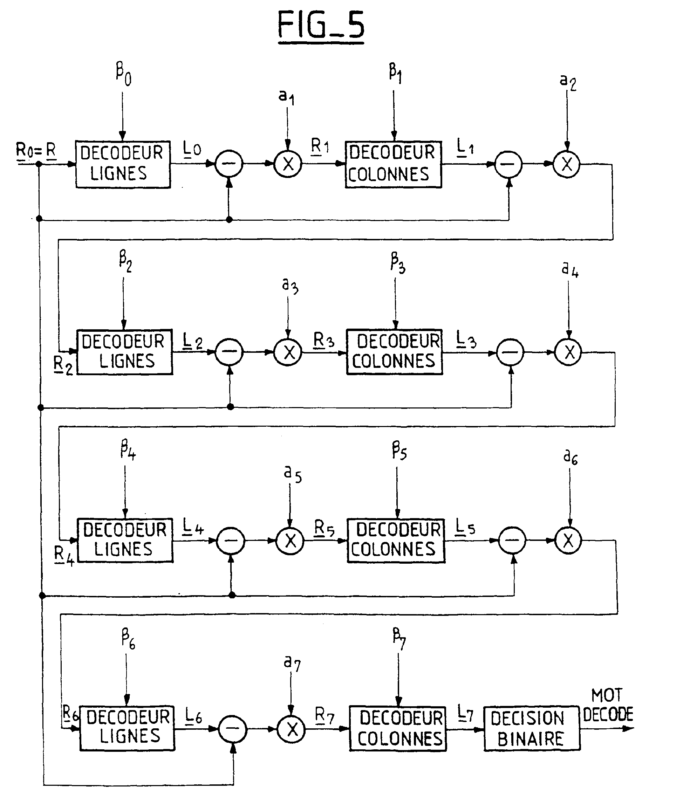

Le schéma de la figure 5 illustre le fonctionnement du décodeur pour un nombre d'itérations égal à 4.

Le procédé de l'invention s'applique à tous les types de codes en blocs linéaires, tels les codes BCH, y compris les codes de Reed-Solomon, Reed-Muller, QR, les codes cycliques, etc., sans utiliser des décodeurs algébriques et des calculs compliqués dans les corps finis de Gallois.

Les figures 6 et 7 montrent des résultats de décodage selon l'invention. La figure 6 montre les résultats d'un décodage du code produit BCH(31, 21) étendu, selon le procédé décrit en référence à la figure 4 et à la figure 1. On a porté en ordonnées sur la figure le taux d'erreur sur les bits, et en abscisses le rapport signal sur bruit Eb/N0, en dB. On a représenté sur la figure les résultats obtenus pour le code convolutif 1/2 de longueur de contrainte 7, et les résultats obtenus après une, deux, trois ou quatre itérations de décodage selon l'invention.

Pour la simulation de la figure 6, on a calculé (étape 5 de la figure 1), J=50 mots de code, dont on a retenu à chaque fois les Q=19 meilleurs. Les coefficients $(a_i)$ utilisés pour les lignes et les colonnes sont donnés dans le tableau suivant:

| $a_1$ $a_2$ | $a_3$ | $a_4$ | $a_5$ | $a_6$ | $a_7$ | $a_8$ |
|---|---|---|---|---|---|---|
| 0,0 0,3 | 0,5 | 0,7 | 0,9 | 1 | 1 | 1 |

Les coefficients $(b_i)$ ci-dessous sont utilisés dans le cas où l'on n'a pas trouvé de mots de code concurrent:

| $b_1$ | $b_2$ | $b_3$ | $b_4$ | $b_5$ | $b_6$ | $b_7$ | $b_8$ |
|---|---|---|---|---|---|---|---|
| 0,2 | 0,3 | 0,6 | 0,8 | 1 | 1 | 1 | 1 |

La figure montre un gain de codage de près de 2 dB par rapport au code 1/2, et ce dès un TEB de $10^{-6}$.

La figure 7 montre des résultats correspondants, pour un code produit BCH(30, 19) x BCH(30, 24). Le code BCH(30, 19) est un code raccourci de 2 obtenu à partir du code BCH(31, 21) étendu. Le code BCH(30, 24) est un code raccourci de 2 obtenu à partir du code BCH(31, 26) étendu. On retrouve un gain de codage supérieur à 2dB, par rapport au même code de référence.

Dans tous ses modes de réalisation, le décodage itératif de codes produits selon l'invention fournit de meilleures performances avec le même nombre d'itérations que l'algorithme proposé dans FR-A-2 712 760.

Bien entendu, la présente invention n'est pas limitée aux exemples et modes de réalisation décrits et représentés, mais elle est susceptible de nombreuses variantes accessibles à l'homme de l'art. Ainsi, l'invention a été décrite en référence à un code produit C1.C2; elle s'applique à des codes de formes différentes, comme par exemple des codes produits de trois codes en blocs ou plus; elle s'applique aussi à des codes produits du type de ceux décrits dans la demande de brevet n° 9712594 susmentionnée de la demanderesse. Ces codes produits sont d'une application particulière au codage des paquets en transmission en mode transfert asynchrone (ATM): on utilise pour le codage des en-têtes un code $C_1$ différent du code C2 utilisé pour le corps du paquet. On applique ensuite aux colonnes de la matrice dont les lignes sont formée des mots des codes C1 et C2 un code C3.

De même, on peut utiliser les procédés des figures 1 à 3 pour d'autres algorithmes de décodage itératif que celui de la figure 4.

Il est aussi clair que la formulation en termes de "lignes" et "colonnes" du mot de code produit reçu n'est employée que pour la commodité d'expression, et que les valeurs reçues sur le canal ne sont pas sous forme d'une matrice. On peut indifféremment commencer à décoder par les "lignes" ou par les "colonnes". L'expression "mots d'un code produit reçus en sortie d'un canal de transmission" doit donc s'entendre d'une valeurs successives, ou encore d'une suite de valeurs binaires entachés d'un bruit, qui sont reçues en sortie d'un canal de transmission.

En outre, l'invention a été décrite en référence à des codes en blocs systématiques. Elle s'applique pour ce qui concerne les méthodes des premier et troisième modes de réalisation à des codes C(n, k, d) qui ne sont pas sous une forme systématique, dans la mesure où ils peuvent facilement être transformés en codes sous une forme systématique, par produit par une matrice de rang k. Elle a été décrite en référence à l'exemple de codes binaires, mais elle s'applique aussi à des codes q-aires, avec $q \neq 2$.

**Revendications**

1. Procédé de décodage à entrée souple et à sortie souple d'un mot ($\underline{s}$) d'un code linéaire en bloc de dimension k et de longueur n, reçu depuis un canal de transmission, comprenant les étapes de

   - génération d'une liste de mots fermes ($\underline{u}_b$) du code proches du mot de code reçu ($\underline{s}$), en codant une liste de k-uplets les plus vraisemblables;
   - calcul de la j-ième composante du mot souple de sortie par différence entre les métriques d'une part du mot de code généré le plus proche, et d'autre part, et du mot de code généré le plus proche ayant une j-ième composante opposée, chacun des k-uplets de la liste de k-uplets étant obtenu par:
   - classement par ordre de fiabilité des composantes du mot de code reçu, suivant une permutation (T);
   - vérification que les k composantes les plus fiables du mot ainsi obtenu permettent de générer les n - k autres;
   - choix de valeurs fermes pour m composantes les moins fiables desdites k composantes, m étant un entier inférieur à k;
   - approximation ferme des k - m autres composantes;
   - codage du mot ferme ainsi obtenu, par un code égal à la composition dudit code par l'inverse de ladite permutation.

2. Procédé selon la revendication 1, **caractérisé en ce que** les k-uplets les plus vraisemblables sont obtenus par approximation ferme des composantes du mot reçu et par changement des composantes des moins fiables,

3. Procédé selon la revendication 1, dans lequel la vérification s'effectue par

   - application aux colonnes de la matrice de parité du code de la permutation;
   - vérification du rang de la matrice formée des n-k dernières colonnes de la matrice de parité ainsi permutée.

4. Procédé selon la revendication 1 ou 4, dans lequel l'étape de vérification, lorsqu'elle est négative, est suivie d'une étape de modification de la permutation.

5. Procédé selon la revendication 1 ou 2, dans lequel chacun des k-uplets de la liste de k-uplets est obtenu par:

   - classement par ordre de fiabilité des k premières composantes du mot de code reçu, par une permutation (T);
   - choix de valeurs fermes pour m composantes les moins fiables, m étant un entier inférieur à k;
   - approximation ferme des k - m autres composantes;
   - codage du mot ferme ainsi obtenu, par un code égal à la composition dudit code par l'inverse de ladite permutation.

6. Procédé selon l'une des revendications 1 à 5, **caractérisé en ce que** le calcul de la j-ième composante du mot souple de sortie s'effectue, lorsqu'il n'existe pas de mot de code généré le plus proche ayant une j-ième composante opposée, par différence entre les métriques d'une part du mot de code généré le plus proche, et d'autre part, et du mot de code généré le moins proche

7. Procédé selon l'une des revendications 1 à 5, **caractérisé en ce que** le calcul de la j-ième composante du mot souple de sortie s'effectue, lorsqu'il n'existe pas de mot de code généré le plus proche ayant une j-ième composante opposée, par addition à la j-ième composante du mot reçu d'un coefficient affecté du signe de la décision ferme de la j-ième composante du mot de code le plus proche reçu.

8. Procédé selon l'une des revendications précédentes, **caractérisé en ce que** le mot reçu est affecté d'un bruit blanc additif et gaussien.

9. Procédé de décodage à entrée souple et à sortie souple d'un mot ($\underline{s}$) d'un code linéaire en bloc de dimension k et de longueur n, reçu depuis un canal de transmission, comprenant les étapes de

   - choix du mot de code le plus proche du mot reçu dans une liste de mots fermes ($\underline{u}_b$) du code proches du mot de code reçu ($\underline{s}$), générés en codant une liste de k-uplets les plus vraisemblables,
   - pour chaque composante d'ordre j du mot reçu, j variant de 1 à n:

     * remplacement de la j-ième composante du mot reçu par l'inverse de la j-ième composante du dit mot de code de plus proche;
     * choix du mot de code le plus proche du mot obtenu dans l'étape de remplacement dans une liste de mots fermes du code proches du mot de code obtenu dans l'étape de remplacement, générés en codant une liste de k-uplets les plus vraisemblables;
     * calcul de la j-ième composante du mot souple de sortie par différence entre les métriques d'une part du mot de code le plus proche du mot reçu, et d'autre part, et du mot de code le plus proche du mot obtenu dans l'étape de remplacement.

10. Procédé selon la revendication 9, **caractérisé en ce que** dans l'étape du choix du mot de code le plus proche du mot reçu, les k-uplets les plus vraisemblables sont obtenus par approximation ferme des composantes les plus fiables du mot reçu et par changement des composantes les moins fiables.

11. Procédé selon la revendication 9 ou 10, **caractérisé en ce que** dans l'étape du choix du mot de code le plus proche du mot obtenu dans l'étape de remplacement, les k-uplets les plus vraisemblables sont obtenus par approximation ferme des composantes les plus fiables du mot obtenu dans l'étape de remplacement et par changement des composantes les moins fiables.

12. Procédé selon l'une des revendications 9 à 1&, **caractérisé en ce que** le mot reçu est affecté d'un bruit blanc additif et gaussien.

13. Un procédé de décodage itératif d'un mot ($\underline{R}$) d'un code produit reçu depuis un canal de transmission, comprenant pour au moins une itération, un décodage à entrée souple et à sortie souple de lignes ou de colonnes dudit mot du code produit, selon le procédé de l'une des revendications 1 à 12.

**Claims**

1. Method of soft input and soft output decoding of a word ($\underline{s}$) of a block linear code of dimension k and length n, received from a transmission channel, comprising the steps of

   - generating a list of firm words ($\underline{u}_b$) of the code that are close to the received code word ($\underline{s}$) by coding a list of the most likely k-tuples,
   - calculating the j-th component of the output soft word by differencing between the metrics on the one hand of the closest generated code word and, on the other hand, and of the closest generated code word having an opposite j-th component,
   each of the k-tuples of the list of k-tuples being obtained by
   - ranking in order of reliability the components of the received code word, according to a permutation (T),
   - verifying that the k most reliable components of the word thus obtained make it possible to generate the n-k others,
   - choosing firm values for the m least reliable components of said k components, m being an integer less than k,
   - firmly approximating the other k-m components,
   - coding the firm word thus obtained by a code equal to the composition of said code with the inverse of said permutation.

2. Method according to Claim 1, **characterized in that** the most likely k-tuples are obtained by firmly approximating the components of the received word and by changing the least reliable components.

3. Method according to Claim 1, in which the verification is performed by

   - applying the code of the permutation to the columns of the parity matrix,

- verifying the rank of the matrix formed of the last n-k columns of the thus permuted parity matrix.

4. Method according to Claim 1 or 4, in which the verification step, when it is negative, is followed by a step of modifying the permutation.

5. Method according to Claim 1 or 2, in which each of the k-tuples of the list of k-tuples is obtained by

    - ranking in order of reliability the first k components of the received code word, by a permutation (T),
    - choosing firm values for the m least reliable components, m being an integer less than k,
    - firmly approximating the other k-m components,
    - coding the firm word thus obtained, by a code equal to the composition of said code with the inverse of said permutation.

6. Method according to one of Claims 1 to 5, **characterized in that**, when there is no closest generated code word having an opposite j-th component, the j-th component of the output soft word is calculated by differencing between the metrics of on the one hand the closest generated code word, and on the other hand, and of the furthest generated code word.

7. Method according to one of Claims 1 to 5, **characterized in that**, when there is no closest generated code word having an opposite j-th component, the j-th component of the output soft word is calculated by adding to the j-th component of the received word a coefficient assigned the sign of the firm decision of the j-th component of the closest code word received.

8. Method according to any one of the preceding claims, **characterized in that** the received word is affected by additive Gaussian white noise.

9. Method of soft input and soft output decoding of a word ($\underline{s}$) of a block linear code of dimension k and length n, received from a transmission channel, comprising the steps of

    - choosing the code word closest to the received word from a list of firm words ($\underline{u}_b$) of the code that are close to the code word received ($\underline{s}$) and are generated by coding a list of the most likely k-tuples,
    - for each component of order j of the received word, j varying from 1 to n:

        * replacing the j-th component of the received word by the inverse of the j-th component of said nearest code word,
        * choosing the code word nearest to the word obtained in the replacement step from a list of firm words of the code that are close to the code word obtained in the replacement step and are generated by coding a list of the most likely k-tuples,
        * calculating the j-th component of the output soft word by differencing between the metrics on the one hand of the code word nearest to the received word, and on the other hand, and of the code word nearest to the word obtained in the replacement step.

10. Method according to Claim 9, **characterized in that** in the step of choosing the code word closest to the received word, the most likely k-tuples are obtained by firmly approximating the most reliable components of the received word and by changing the least reliable components.

11. Method according to Claim 9 or 10, **characterized in that** in the step of choosing the code word closest to the word obtained in the replacement step, the most likely k-tuples are obtained by firmly approximating the most reliable components of the word obtained in the replacement step and by changing the least reliable components.

12. Method according to one of Claims 9 to 11, **characterized in that** the received word is affected by additive Gaussian white noise.

13. Method of iterative decoding of a word ($\underline{R}$) of a product code received from a transmission channel, comprising for at least one iteration, a soft input and soft output decoding of rows or columns of said word of the product code, according to the method of one of Claims 1 to 12.

**Patentansprüche**

1. Verfahren zur Decodierung mit Soft-Eingang und Soft-Ausgang eines Worts ($\underline{s}$) eines linearen Blockcodes der Dimension k und Länge n, das von einem Übertragungskanal empfangen wird, umfassend die Schritte des

   - Erzeugens einer Liste fester Worte ($\underline{u_b}$) des Codes, die nahe dem empfangenen Codewort ($\underline{s}$) sind, indem eine Liste der wahrscheinlichsten k-Tupel codiert wird,
   - Berechnens der j-ten Komponente des Soft-Ausgangsworts durch Differenzberechnung zwischen den Metriken des erzeugten allernächsten Codeworts einerseits und andererseits des erzeugten allernächsten Codeworts, das eine j-te entgegengesetzte Komponente aufweist,

   wobei jedes der k-Tupel aus der Liste der k-Tupel erhalten wird durch:

   - Einteilen der Komponenten des empfangenen Codeworts in einer Reihenfolge der Zuverlässigkeit gemäß einer Permutation (T),
   - Überprüfen, dass die zuverlässigsten k Komponenten des auf diese Weise erhaltenen Worts das Erzeugen der sonstigen n - k ermöglichen,
   - Wählen fester Werte für die am wenigsten zuverlässigen m Komponenten der k Komponenten, wobei m eine k unterschreitende Ganzzahl ist,
   - festes Approximieren der k - m sonstigen Komponenten,
   - Codieren des auf diese Weise erhaltenen festen Worts durch einen Code, der gleich der Komposition des Codes durch die Umkehrfunktion der Permutation ist.

2. Verfahren nach Anspruch 1, **dadurch gekennzeichnet, dass** die wahrscheinlichsten k-Tupel durch festes Approximieren der Komponenten des empfangenen Worts und durch Ändern der am wenigsten zuverlässigen Komponenten erhalten werden.

3. Verfahren nach Anspruch 1, bei dem die Überprüfung erfolgt durch

   - Anwenden des Codes der Permutation auf den Spalten der Paritätsmatrix,
   - Überprüfen des Rangs der gebildeten Matrix der n - k letzten Spalten der auf diese Weise permutierten Paritätsmatrix.

4. Verfahren nach Anspruch 1 oder 4, bei dem der Schritt des Überprüfens, wenn er negativ ist, von einem Schritt des Änderns der Permutation gefolgt wird.

5. Verfahren nach Anspruch 1 oder 2, bei dem jedes der k-Tupel aus der Liste der k-Tupel erhalten wird durch:

   - Einteilen der k ersten Komponenten des empfangen Codeworts in einer Reihenfolge der Zuverlässigkeit durch eine Permutation (T),
   - Wählen von festen Werten für die am wenigsten zuverlässigen m Komponenten, wobei m eine k unterschreitende Ganzzahl ist,
   - festes Approximieren der k - m sonstigen Komponenten,
   - Codieren des auf diese Weise erhaltenen festen Wortes durch einen Code, der gleich der Komposition des Codes durch die Umkehrfunktion der Permutation ist.

6. Verfahren nach einem der Ansprüche 1 bis 5, **dadurch gekennzeichnet, dass**, wenn kein erzeugtes allernächstes Codewort besteht, welches eine entgegengesetzte j-te Komponente aufweist, das Berechnen der j-ten Komponente des Soft-Ausgangsworts durch Differenzberechnung zwischen den Metriken des erzeugten allernächsten Codeworts einerseits und andererseits des erzeugten am wenigsten nahen Codeworts erfolgt.

7. Verfahren nach einem der Ansprüche 1 bis 5, **dadurch gekennzeichnet, dass**, wenn kein erzeugtes allernächstes Codewort besteht, welches eine entgegengesetzte j-te Komponente aufweist, das Berechnen der j-ten Komponente des Soft-Ausgangsworts durch Addition zur j-ten Komponente des empfangenen Worts eines Koeffizienten, der mit dem Zeichen der festen Entscheidung der j-ten Komponente des empfangenen allernächsten Codeworts behaftet ist, erfolgt.

8. Verfahren nach einem der vorhergehenden Ansprüche, **dadurch gekennzeichnet, dass** das empfangene Wort von einem additiven weißen und Gaußschen Rauschen behaftet ist.

9.  Verfahren zur Decodierung mit Soft-Eingang und Soft-Ausgang eines Worts ($\underline{s}$) eines linearen Blockcodes der Dimension k und Länge n, das über einen Übertragungskanal empfangen wird, umfassend die Schritte des

    - Wählens des Codeworts, das allernächst zum empfangenen Wort ist in einer Liste fester Worte ($\underline{u}_b$) des Codes, die nahe dem empfangen Codewort ($\underline{s}$) sind, welche durch Codierung einer Liste der wahrscheinlichsten k-Tupel erzeugt werden,
    - für jede Komponente der j-Reihenfolge des empfangenen Worts, wobei j von 1 bis n variiert:

      * Ersetzen der j-ten Komponente des empfangenen Worts durch die Umkehrfunktion der j-ten Komponente des am nächsten liegenden Codeworts,
      * Wählen des Codeworts, das allernächst zum beim Schritt des Ersetzens erhaltenen Wort ist in einer Liste fester Worte des Codes, die nahe dem beim Schritt des Ersetzens erhaltenen Codewort sind, welche durch Codierung einer Liste der wahrscheinlichsten k-Tupel erzeugt werden,
      * Berechnen der j-ten Komponente des Soft-Ausgangsworts durch Differenzberechnung zwischen den Metriken des Codeworts einerseits, das allernächst zum empfangenen Wort ist und andererseits des Codeworts, das allernächst zum beim Schritt des Ersetzens erhaltenen Wort ist.

10. Verfahren nach Anspruch 9, **dadurch gekennzeichnet, dass** beim Schritt des Wählens des Codeworts, das allernächst zum empfangenen Wort ist, die wahrscheinlichsten k-Tupel durch festes Approximieren der zuverlässigsten Komponenten des empfangenen Worts erhalten werden und durch Änderung der am wenigsten zuverlässigen Komponenten.

11. Verfahren nach Anspruch 9 oder 10, **dadurch gekennzeichnet, dass** beim Schritt des Wählens des Codeworts, das dem beim Schritt des Ersetzens erhaltenen Worts allernächst ist, die wahrscheinlichsten k-Tupel durch festes Approximieren der zuverlässigsten Komponenten des Worts erhalten werden, das beim Schritt des Ersetzens erhalten wird und durch Ändern der am wenigsten zuverlässigen Komponenten.

12. Verfahren nach einem der Ansprüche 9 bis 11, **dadurch gekennzeichnet, dass** das empfangene Wort von einem additiven weißen und Gaußschen Rauschen behaftet ist.

13. Verfahren zur iterativen Decodierung eines Worts ($\underline{R}$) eines von einem Übertragungskanal empfangenen Produktcodes, umfassend eine Decodierung mit Soft-Eingang und mit Soft-Ausgang von Zeilen oder Spalten des Worts des Produktcodes nach dem Verfahren eines der Ansprüche 1 bis 12 für mindestens eine Iteration.

# FIG_1

TRI DES $n_1$ COMPOSANTES $S_i$ SUIVANT L'ORDRE CROISSANT DES MODULES $|S_i|$ —— 1

VERIFICATION DE L'INDEPENDANCE DES $n_1-k_1$ DERNIERES COLONNES DE LA MATRICE PERMUTEE, SINON, MODIFICATION MINIMALE DE LA PERMUTATION —— 2

GENERATION DE $2^m$ m-UPLETS BINAIRES EN COMBINANT TOUTES LES INVERSIONS POSSIBLES SUR m COMPOSANTES —— 3

PRISE DE DECISION FERME POUR LES $k_1-m$ COMPOSANTES RESTANTES —— 4

RECONSTITUTION DES $k_1$-UPLETS & CODAGE —— 5

CALCUL DES METRIQUES DES $2^m$ MOTS DE CODE —— 6

POUR TOUT $j \leqslant n_1$
$$V_j = \frac{1}{4}(C_{j-} - C_{j+})$$
—— 7

TRI DES $k_1$ PREMIÈRES COMPOSANTES Si
SUIVANT L'ORDRE CROISSANT DES $|Si|$ — 11

GENERATION DE $2^m$ m-uplets binaires pour
les m composantes les moins fiables — 12

PRISE DE DECISION FERME SUR
LES $k_1-n$ COMPOSANTES RESTANTES — 13

RECONSTITION DES $k_1$ UPLETS & CODAGE — 14

CALCUL DES METRIQUES DES $2^m$ MOTS DE CODE — 15

POUR TOUT $j \leqslant n_1$
$Vj = \frac{1}{4}(Cj_- - Cj_+)$ — 16

$\underline{FIG\_2}$

DETERMINATION LISTE MOTS
DE CODES PROCHES
20 —

CHOIX DU MOT $\underline{C}^*$ LE
PLUS PROCHE
21 —

CHANGEMENT DE LA $J^{-IEME}$
COMPOSANTE DU MOT RECU
22 —

DETERMINATION LISTE MOTS
DE CODES PROCHES
23 —

CALCUL DES DIFFERENCES DES
METRIQUES LES PLUS FAIBLES
24 —

$\underline{FIG\_3}$

25 — $j = n$   Non

$j := j+1$

27

Oui

DECODAGE
TERMINE
26 —

# FIG_4

30 —— $\underline{R}i := \underline{R} \qquad i := 0$

32 —— DETERMINATION DES CŒFFICIENTS (a$i$)

34 —— DECODAGE DES LIGNES DE $\underline{R}i$
OBTENTION DE LA MATRICE $\underline{L}i$

36 —— $i := i+1$
$\underline{R}i := R + ai(\underline{L}_{i-1} - \underline{R}_{i-1})$

38 —— DECODAGE DES COLONNES DE $\underline{R}i$
OBTENTION DE LA MATRICE $\underline{L}i$

40 —— $i := i+1$
$Ri := R + ai(\underline{L}_{i-1} - \underline{R}_{i-1})$

42 —— $i/2 =$ nombre d'itérations    Non

Oui

46 —— FIN
EXTRAIRE DE $\underline{L}i-1$ L'INFORMATION

# FIG_5

## FIG_6

TEB

$10^0$

$10^{-2}$

$10^{-4}$

$10^{-6}$

0          1          2          3          4          dB

Eb/NO

- — — — 1 iter
- ------- 2 iter
- —··—··— 3 iter
- —·—·— 4 iter
- ——— Code 1/2
  convolutif, K=7

## FIG_7

TEB

$10^0$

$10^{-2}$

$10^{-4}$

$10^{-6}$

$10^{-8}$

0          1          2          3          4          dB

Eb/NO

- — — — teb1
- ------- teb2
- —··—··— teb3
- —·—·— teb4
- ——— code 1/2, K=7

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 9712594

- FR 2712760 A

**Littérature non-brevet citée dans la description**

- **MARC FOSSORIER.** *Soft-Decision Decoding of Linear Block Codes Based on Ordered Statistics,* 05 Septembre 1995